# FASCICULE DE BREVET EUROPEEN

(11) **EP 1 694 597 B1**
(45) Date de publication et mention de la délivrance du brevet: **15.08.2007**
(21) Numéro de dépôt: 04805699.8
(22) Date de dépôt: 14.12.2004
(51) Int. Cl.: B81B 7/00, G01P 1/02

(54) **MICROCOMPOSANT COMPORTANT UNE MICROCAVITE HERMETIQUE ET PROCEDE DE FABRICATION D UN TEL MICROCOMPOSANT**
MIKROKOMPONENTE MIT EINER HERMETISCHEN MIKROKAVITÄT UND VERFAHREN ZUR HERSTELLUNG SOLCH EINER MIKROKOMPONENTE
MICROCOMPONENT COMPRISING A HERMETIC MICROCAVITY AND METHOD FOR PRODUCTION OF SUCH A MICROCOMPONENT

(30) Priorité: 19.12.2003 FR 0315029
(43) Date de publication de la demande: 30.08.2006
(73) Titulaire: COMMISSARIAT A L'ENERGIE ATOMIQUE, 75752 Paris Cédex 15 (FR)
(72) Inventeur: ROBERT, Philippe, F-38100 Grenoble (FR)
(74) Mandataire: Jouvray, Marie-Andrée
(86) Numéro de dépôt international: PCT/FR2004/003216
(87) Numéro de publication internationale: WO 2005/061374

(56) Documents cités:
- EP-A- 0 451 992
- DE-A- 10 005 555
- BARTEK M ET AL: "Vacuum sealing of microcavities using metal evaporation" SENSORS AND ACTUATORS A, ELSEVIER SEQUOIA S.A., LAUSANNE, CH, vol. 60, no. 1-3, 1 mai 1997 (1997-05-01), pages 364-368, XP004089097 ISSN: 0924-4247
- FURTSCH M ET AL: "Texture and stress profile in thick polysilicon films suitable for fabrication of microstructures" THIN SOLID FILMS, ELSEVIER-SEQUOIA S.A. LAUSANNE, CH, vol. 296, no. 1-2, 1 mars 1997 (1997-03-01), pages 177-180, XP004111577 ISSN: 0040-6090

## Description

### Domaine technique de l'invention

L'invention concerne un microcomposant comportant une microcavité hermétique délimitée par un capot comportant une première couche, dans laquelle est formé au moins un orifice, et une deuxième couche rendant la microcavité hermétique, microcomposant comportant une troisième couche disposée entre la première et la deuxième couche, une microcavité additionnelle, communiquant avec l'orifice et disposée entre la première et la troisième couche, et au moins un orifice additionnel, adjacent à la microcavité additionnelle, formé dans la troisième couche, décalé par rapport à l'orifice et bouché par la deuxième couche.

### État de la technique

L'encapsulation hermétique des microsystèmes électromécaniques est nécessaire pour plusieurs raisons. La poussière et l'humidité peuvent, notamment, perturber le fonctionnement des parties mobiles et les contacts électriques peuvent être dégradés par l'oxygène de l'air ambiant.

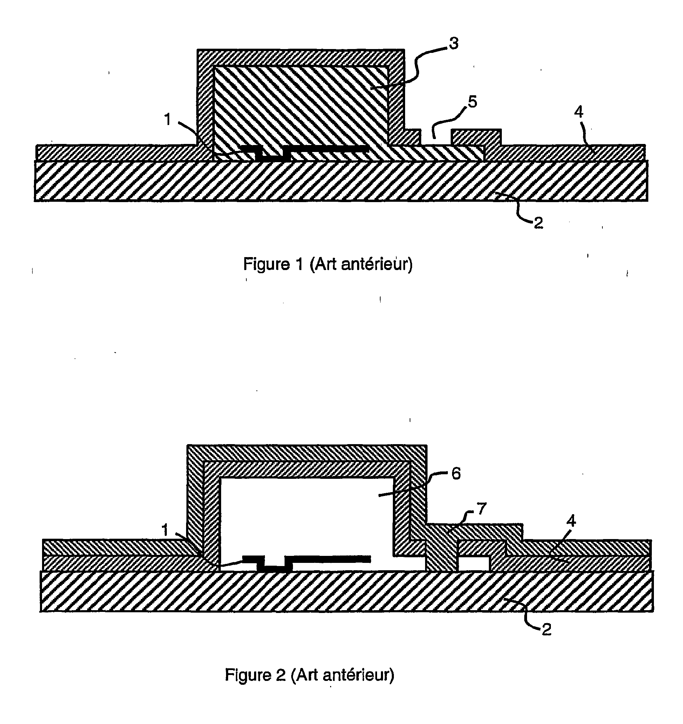

Classiquement, les microsystèmes électromécaniques sont enfermés dans une microcavité hermétique délimitée par un capot. Un procédé de fabrication connu d'un capot hermétique est représenté sur les figures 1 et 2. Les microsystèmes électromécaniques 1 sont généralement disposés sur un substrat 2. Comme représenté à la figure 1, le capot est formé, sur le substrat 2 et sur une couche sacrificielle 3 formée sur le substrat 2, par une première couche 4 dans laquelle est formé un orifice 5 ou, éventuellement, plusieurs orifices 5. Puis, la couche sacrificielle 3 est enlevée par l'intermédiaire de l'orifice 5, de manière à obtenir une microcavité 6, comme représenté à la figure 2. Ensuite, une deuxième couche 7, ou couche de bouchage, est déposée sur la première couche 4, de manière à rendre la microcavité 6 hermétique.

La fabrication par l'intermédiaire d'une couche sacrificielle 3 présente, entre autres, deux problèmes, à savoir une herméticité insuffisante et une durée importante de l'étape de retrait de la couche sacrificielle 3, en particulier dans le cas de capots de taille importante.

En effet, afin d'assurer un bouchage hermétique du capot, les orifices 5 sont typiquement de petite taille et localisés dans des zones de faible épaisseur de la couche sacrificielle 3, et en conséquence de la microcavité 6, comme représenté à la figure 1. Typiquement, l'épaisseur de la couche sacrificielle 3 à l'emplacement de l'orifice 5, dans une zone périphérique de la microcavité 6, est de l'ordre de 0,5 microns, tandis que l'épaisseur de la couche sacrificielle 3 recouvrant les microsystèmes électromécaniques 1 est de l'ordre de 10 microns. L'étape de gravure de la couche sacrificielle 3 est alors longue et difficile. Cet inconvénient est d'autant plus prononcé que, pour assurer au mieux le bouchage, l'épaisseur de la couche sacrificielle 3 à l'emplacement de l'orifice 5 est diminuée, parfois en dessous de 0,2 microns.

Le document DE10005555 décrit un microcomposant comportant une cavité hermétique délimitée par un capot. Le capot comporte des couches inférieure et supérieure ayant respectivement des orifices décalés les uns par rapport aux autres et disposés à la partie supérieure du capot. Au cours du procédé de fabrication du microcomposant, les couches inférieure et supérieure sont déposées sur des première et seconde couches sacrificielles. L'enlèvement des couches sacrificielles est effectué à travers les orifices de la couche supérieure. La première couche sacrificielle est, de plus, enlevée à travers les orifices de la couche inférieure. La couche supérieure forme des ponts s'étendant au-dessus des orifices de la couche inférieure et disposés entre deux orifices de la couche supérieure. Les orifices des couches supérieure et inférieure communiquent respectivement entre eux par l'intermédiaire de cavités additionnels disposées entre la couche inférieure et la couche supérieure. Lors du procédé de fabrication, les cavités additionnelles sont réalisées au moyen de la seconde couche sacrificielle. En fin de procédé, les orifices de la couche supérieure sont bouchés par une couche de fermeture déposée sur la couche supérieure et formant des bouchons dans les orifices. La couche inférieure peut être réalisée sous une contrainte mécanique de tension intrinsèque.

L'article "Vacuum sealing of microcavities using metal evaporation" de M. Bartek et al. (Sensors and Actuators A 61 (1997) 364-368) décrit un procédé de fabrication d'un microcomposant. Une couche sacrificielle est déposée dans une cavité d'un substrat et recouverte partiellement par une couche en nitrure de silicium, de manière à laisser un orifice débouchant sur la couche sacrificielle. La couche en nitrure de silicium est sous faible contrainte mécanique. Puis, une seconde couche sacrificielle est déposée dans l'orifice et à la périphérie de l'orifice. La seconde couche sacrificielle est ensuite recouverte partiellement par une couche en polysilicium. Les couches sacrificielles sont enlevées et les cavités obtenues sont fermées par dépôt d'une couche de scellement en aluminium ou polysilicium. On obtient un microcomposant comportant une microcavité hermétique couverte par un capot. Le capot est constitué successivement par la couche en nitrure de silicium, la couche en polysilicium et la couche de scellement. Entre la couche en nitrure de silicium et la couche en polysilicium est disposée une petite microcavité supplémentaire, à travers laquelle la couche sacrificielle est enlevée lors du procédé.

Le document EP0451992 décrit un microcomposant comportant une cavité disposée entre un substrat et un capot suspendu entre deux éléments. A l'intérieur de la cavité est disposée une poutre suspendue. La cavité communique avec l'extérieur par l'intermédiaire de canaux qui sont bouchés par une couche d'oxyde. Le procédé de fabrication comporte une étape de recuit afin d'obtenir le niveau souhaité de tension et de déformation de la poutre.

### Objet de l'invention

L'invention a pour but de remédier à ces inconvénients et, en particulier, d'assurer l'herméticité d'une microcavité tout en réduisant la durée du procédé de fabrication de la microcavité.

Selon l'invention, ce but est atteint par les revendications annexées et, en particulier, par le fait que la troisième couche ou la couche de bouchage est une couche sous contrainte mécanique en tension disposée au-dessus de la première couche, ladite couche sous contrainte mécanique en tension fléchissant en direction de la première couche et provoquant une réduction de l'espace à boucher par la couche de bouchage.

L'invention a également pour but un procédé de fabrication d'une microcavité hermétique d'un microcomposant selon l'invention, comportant successivement
- le dépôt, sur un substrat, d'une couche sacrificielle destinée à délimiter la microcavité,
- le dépôt, sur le substrat et la couche sacrificielle, d'une première couche constituant un capot,
- la gravure, dans la première couche, d'au moins un orifice débouchant sur la couche sacrificielle,
- l'enlèvement, à travers l'orifice, de la couche sacrificielle, de manière à créer une microcavité,
- le dépôt d'une couche de bouchage, de manière à rendre la microcavité hermétique,
procédé caractérisé en ce qu'il comporte, après gravure de l'orifice et avant enlèvement de la couche sacrificielle,
- le dépôt d'une couche sacrificielle additionnelle, recouvrant l'orifice et une partie de la première couche, sur la périphérie de l'orifice,
- le dépôt, sur la première couche et sur la couche sacrificielle additionnelle, d'une troisième couche,
- la gravure, dans la troisième couche, d'au moins un orifice additionnel, décalé par rapport à l'orifice et débouchant sur la couche sacrificielle additionnelle,
l'enlèvement de la couche sacrificielle et de la couche sacrificielle additionnelle étant effectué à travers l'orifice additionnel, de manière à créer la microcavité, et le dépôt de la couche de bouchage étant effectuée sur la troisième couche, de manière à boucher l'orifice additionnel, la troisième couche ou la couche de bouchage étant une couche sous contrainte mécanique en tension disposée au-dessus de la première couche, fléchissant en direction de la première couche et provoquant une réduction de l'espace à boucher par la couche de bouchage.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
Les figures 1 et 2 représentent deux étapes d'un procédé de fabrication d'un microcomposant selon l'art antérieur.
Les figures 3, 5, et 7 représentent, en vue de dessus, trois étapes successives d'un mode de réalisation particulier d'un procédé de fabrication d'un microcomposant selon l'invention.
Les figures 4, 6, et 8 représentent, en coupe, respectivement selon les axes A-A, B-B et C-C, les trois étapes représentées figures 3, 5, et 7.
Les figures 9 et 10 illustrent deux étapes ultérieures du procédé selon les figures 3 à 8.
Les figures 11 et 12 représentent deux étapes, précédant le dépôt de la couche de bouchage, d'un autre mode de réalisation particulier d'un procédé de fabrication d'un microcomposant selon l'invention.
La figure 13 représente une étape, précédant le dépôt de la couche de bouchage, d'un autre mode de réalisation particulier d'un procédé de fabrication d'un microcomposant selon l'invention.

### Description de modes particuliers de réalisation

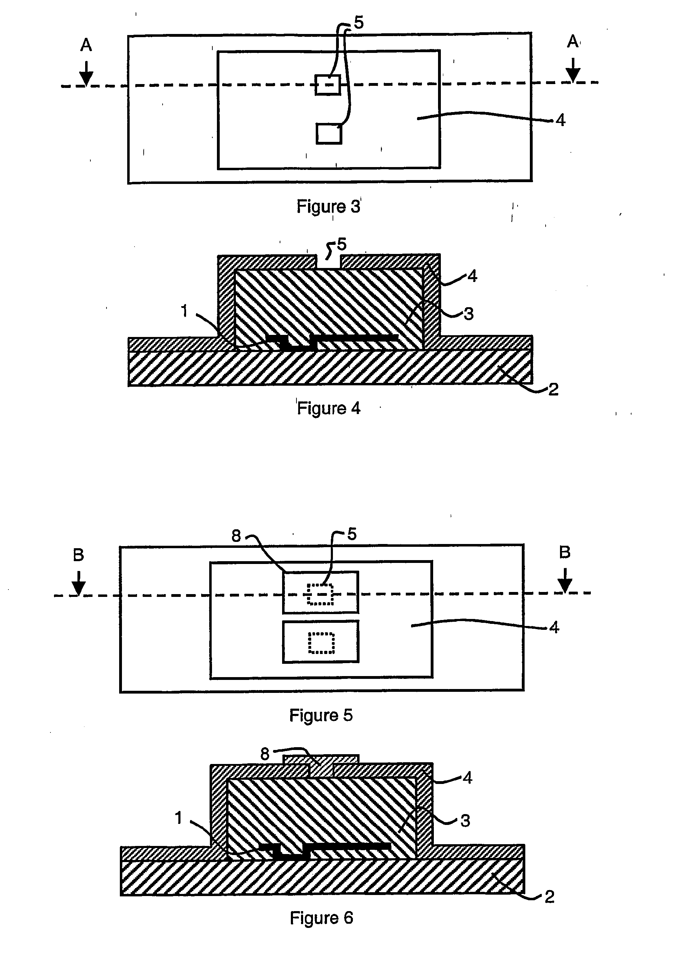

Comme représenté sur les figures 3 et 4, les orifices 5 (deux orifices sur les figures) gravés dans la première couche 4 et débouchant sur la couche sacrificielle 3 sont, de préférence, disposés sur une partie sommitale de la microcavité, c'est-à-dire à des emplacements où la couche sacrificielle 3 a une épaisseur maximale, par exemple de l'ordre de 8 à 10 microns. Ainsi, la durée de l'étape ultérieure de l'enlèvement de la couche sacrificielle 3, à travers les orifices 5, est diminuée sensiblement par rapport à l'art antérieur.

Sur les figures 5 et 6, une couche sacrificielle additionnelle 8, destinée à délimiter une microcavité additionnelle 11, est associée à chacun des orifices 5.

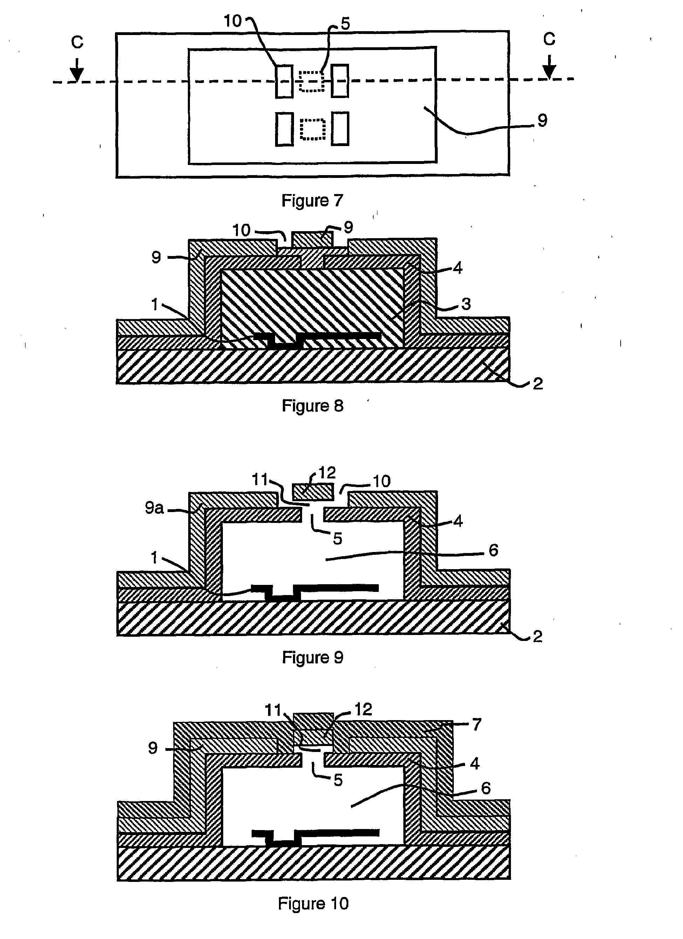

Les couches sacrificielles additionnelles 8 sont déposées, après gravure des orifices 5 et avant enlèvement de la couche sacrificielle 3, de manière à recouvrir les orifices 5 et une partie de la première couche 4, sur la périphérie des orifices 5. L'épaisseur des couches sacrificielles additionnelles 8 est, par exemple, de 0,3 microns. Ensuite, comme représenté aux figures 7 et 8, une troisième couche 9 est déposée sur la première couche 4 et sur les couches sacrificielles additionnelles 8. Puis, est gravé dans la troisième couche 9, au moins un orifice additionnel 10 (deux sur les figures 7 et 8), décalé par rapport à chaque orifice 5 et débouchant sur la couche sacrificielle additionnelle 8 correspondante. Puis, comme représenté à la figure 9, l'enlèvement de la couche sacrificielle 3 et des couches sacrificielles additionnelles 8 est effectué à travers les orifices additionnels 10, de manière à créer la microcavité 6 et la microcavité additionnelle 11, qui communique avec l'orifice 5 correspondant et avec les orifices additionnels 10 correspondants et qui est disposée entre la première couche 4 et la troisième couche 9.

Ensuite, comme représenté à la figure 10, la deuxième couche 7, ou couche de bouchage, est déposée sur la troisième couche 9, de manière à boucher les orifices additionnels 10 et à rendre la microcavité 6 hermétique. Ainsi, la troisième couche 9 est disposée entre la première couche 4 et la deuxième couche 7 avec une microcavité additionnelle 11 entre les première (4) et troisième (9) couches. Les orifices additionnels 10 étant décalés par rapport à l'orifice 5 et débouchant dans la microcavité additionnelle 11, de faible. épaisseur, le bouchage des orifices additionnels 10 par la deuxième couche 7 est simplifié, ce qui permet d'assurer l'herméticité de la microcavité 6.

Sur les figures 7 à 10, deux orifices additionnels 10 sont associés à chaque orifice 5, de manière à ce qu'un pont suspendu 12, formé dans la troisième couche 9 et délimité par les deux orifices additionnels 10, recouvre l'orifice 5. Le décalage entre l'orifice 5 et chaque orifice additionnel 10 est tel qu'aucun orifice additionnel 10 ne recouvre l'orifice 5, même partiellement. Ainsi, la partie de la deuxième couche 7 bouchant les orifices 10 est supportée par la première couche 4 et, ainsi, empêchée de se déposer à l'intérieur de la microcavité 6.

Le matériau des couches sacrificielles 3 et 8 peut être un polymère, par exemple du polyimide ou une résine photosensible, permettant une gravure rapide, par exemple une gravure sèche. Les couches sacrificielles 3 et 8 peuvent également être réalisées par pulvérisation cathodique, de manière à obtenir, par exemple, un verre à phosphosilicate («PSG : phosphosilicate glass») ou une couche métallique, par exemple une couche de tungstène ou une couche de nickel. Les première 4, deuxième 7 et troisième 9 couches peuvent être en dioxyde de silicium (SiO₂), en nitrure de silicium (Si₃N₄) ou en métal. La première couche 4 peut, par exemple, être réalisée par un dépôt de dioxyde de silicium ayant, par exemple, une épaisseur de 1,5 microns. La troisième couche 9 est, de préférence, réalisée par un dépôt de nitrure de silicium d'une épaisseur de 1,5 microns, par exemple. La deuxième couche 7 est, par exemple, en nitrure de silicium et a une épaisseur de 2 microns.

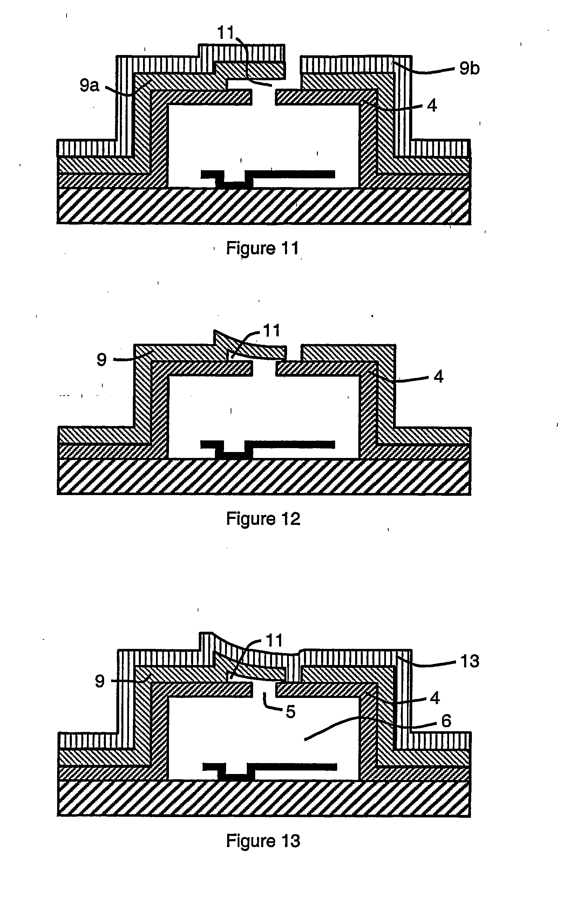

Comme représenté à la figure 11, la troisième couche 9 peut être constituée par un multicouche comprenant au moins deux sous-couches superposées, déposées initialement sur les couches sacrificielles additionnelles 8 et sur la première couche 4. Dans ce cas, une première sous-couche 9a, réalisée sous une contrainte mécanique en tension, est recouverte par une deuxième sous-couche 9b réalisée sous une contrainte mécanique en compression. Les contraintes des première 9a et deuxième 9b sous-couches étant inverses, l'ensemble des première 9a et deuxième 9b sous-couches garde sa forme, après enlèvement des couches sacrificielles 3 et 8. Cependant, comme représenté à la figure 12, une fois la deuxième sous-couche 9b enlevée, la partie de la troisième couche 9 libérée par l'enlèvement de la couche sacrificielle additionnelle 8 correspondante, c'est-à-dire recouvrant la microcavité additionnelle 11 correspondante, fléchit automatiquement en direction de la première couche 4. Ainsi, le passage existant entre l'orifice 5 et l'orifice additionnel 10 pour permettre l'élimination des couches sacrificielles 3 et 8 est rétréci ou même totalement fermé, et, ainsi, l'espace à boucher est réduit, ce qui simplifie l'étape de bouchage. Dans ce cas, dans le microcomposant obtenu, l'orifice additionnel 10, adjacent à la microcavité additionnelle 11, ne communique plus avec cette microcavité additionnelle 11 correspondante.

La troisième couche 9 peut également être réalisée, avant enlèvement des couches sacrificielles 3 et 8, par une seule couche ayant une contrainte mécanique en tension. Au cours de l'enlèvement de la couche sacrificielle additionnelle 8 correspondante, la partie de la troisième couche 9 ainsi libérée fléchit automatiquement en direction de la première couche 4, ce qui prolonge éventuellement l'étape de gravure de la couche sacrificielle 3, mais ce qui présente, comme précédemment, l'avantage d'un bouchage simplifié d'un espace à boucher réduit, sans passer par le biais d'un dépôt de deux sous-couches 9a et 9b.

Dans un autre mode de réalisation, représenté à la figure 13, la troisième couche 9 est réalisée avec un dépôt non contraint, ou légèrement contraint en compression, ce qui, dans ce dernier cas, permet un retrait accéléré des couches sacrificielles 3 et 8 en agrandissant le passage entre les orifices additionnels 10 et l'orifice 5. Ensuite, après enlèvement des couches sacrificielles 3 et 8, une quatrième couche 13 est réalisée, sur la troisième couche 9, avec une contrainte mécanique en tension. La quatrième couche 13 rentre dans l'orifice 10 et bouche l'orifice 10. Les troisième 9 et quatrième 13 couches fléchissent alors en direction de la première couche 4 au fur et à mesure du dépôt de la couche 13, ce qui permet de simplifier le bouchage des orifices additionnels 10.

L'invention n'est pas limitée aux modes de réalisation particuliers représentés. En particulier, le nombre d'orifices 5 peut être quelconque, ainsi que le nombre d'orifices additionnels 10 associés à chaque orifice 5 et débouchant sur la couche sacrificielle additionnelle 8 correspondante. Il est éventuellement possible d'associer une même couche sacrificielle additionnelle 8 à plusieurs orifices 5.

## Revendications

1. Microcomposant comportant une microcavité (6) hermétique délimitée par un capot comportant une première couche (4), dans laquelle est formé au moins un orifice (5), et une couche de bouchage (7, 13) rendant la microcavité (6) hermétique, microcomposant comportant une troisième couche (9) disposée entre la première couche (4) et la couche de bouchage (7, 13), une microcavité additionnelle (11), communiquant avec l'orifice (5) et disposée entre la première (4) et la troisième (9) couche, et au moins un orifice additionnel (10), adjacent à la microcavité additionnelle (11), formé dans la troisième couche (9), décalé par rapport à l'orifice (5) et bouché par la couche de bouchage (7, 13),
microcomposant **caractérisé en ce que** la troisième couche (9) ou la couche de bouchage (13) est une couche sous contrainte mécanique en tension disposée au-dessus de la première couche (4), ladite couche sous contrainte mécanique en tension fléchissant en direction de la première couche (4) et provoquant une réduction de l'espace à boucher par la couche de bouchage (7, 13).

2. Microcomposant selon la revendication 1, **caractérisé en ce que** la microcavité additionnelle (11) communique avec l'orifice additionnel (10).

3. Microcomposant selon l'une des revendications 1 et 2, **caractérisé en ce que** l'orifice (5) est disposé sur une partie sommitale de la microcavité (6).

4. Microcomposant selon l'une quelconque des revendications 1 à 3, **caractérisé en ce que** le décalage entre l'orifice (5) et l'orifice additionnel (10) est tel que l'orifice additionnel (10) ne recouvre pas l'orifice (5), même partiellement.

5. Microcomposant selon l'une quelconque des revendications 1 à 4, **caractérisé en ce que** deux orifices additionnels (10) sont associés à chaque orifice (5), de manière à ce qu'un pont suspendu (12), formé dans la troisième couche (9) et délimité par les deux orifices additionnels (10), recouvre l'orifice (5).

6. Procédé de fabrication d'une microcavité (6) hermétique d'un microcomposant selon l'une quelconque des revendications 1 à 5, comportant successivement
- le dépôt, sur un substrat (2), d'une couche sacrificielle (3) destinée à délimiter la microcavité (6),
- le dépôt, sur le substrat (2) et la couche sacrificielle (3), d'une première couche (4) constituant un capot,
- la gravure, dans la première couche (4), d'au moins un orifice (5) débouchant sur la couche sacrificielle (3),
- l'enlèvement, à travers l'orifice (5), de la couche sacrificielle (3), de manière à créer une microcavité (6),
- le dépôt d'une couche de bouchage (7, 13), de manière à rendre la microcavité (6) hermétique,
procédé **caractérisé en ce qu'**il comporte, après gravure de l'orifice (5) et avant enlèvement de la couche sacrificielle (3),
- le dépôt d'une couche sacrificielle additionnelle (8), recouvrant l'orifice (5) et une partie de la première couche (4), sur la périphérie de l'orifice (5),
- le dépôt, sur la première couche (4) et sur la couche sacrificielle additionnelle (8), d'une troisième couche (9),
- la gravure, dans la troisième couche (9), d'au moins un orifice additionnel (10), décalé par rapport à l'orifice (5) et débouchant sur la couche sacrificielle additionnelle (8),
l'enlèvement de la couche sacrificielle (3) et de la couche sacrificielle additionnelle (8) étant effectué à travers l'orifice additionnel (10), de manière à créer la microcavité (6), et le dépôt de la couche de bouchage (7, 13) étant effectuée sur la troisième couche (9), de manière à boucher l'orifice additionnel (10), la troisième couche (9) ou la couche de bouchage (13) étant une couche sous contrainte mécanique en tension disposée au-dessus de la première couche (4), fléchissant en direction de la première couche (4) et provoquant une réduction de l'espace à boucher par la couche de bouchage (7, 13).

7. Procédé selon la revendication 6, **caractérisé en ce que** la troisième couche (9) est réalisée sous une contrainte mécanique en tension, de manière à ce que la partie de la troisième couche (9) libérée par l'enlèvement de la couche sacrificielle additionnelle (8) fléchisse en direction de la première couche (4).

8. Procédé selon la revendication 6, **caractérisé en ce que** la troisième couche (9) est constituée par une première sous-couche (9a) réalisée sous une contrainte mécanique en tension et recouverte par une deuxième sous-couche (9b) réalisée sous une contrainte mécanique en compression, la deuxième sous-couche (9b) étant enlevée après enlèvement des couches sacrificielles (3, 8).

9. Procédé selon la revendication 6, **caractérisé en ce que** la couche de bouchage (13) est formée après enlèvement des couches sacrificielles (3, 8) sur la troisième couche (9), sous une contrainte mécanique en tension, de manière à ce que la troisième couche (9) et la couche de bouchage (13) fléchissent en direction de la première couche (4).

## Claims

1. Microcomponent comprising a hermetically-sealed microcavity (6) delineated by a cover comprising a first layer (4), in which at least one hole (5) is formed, and a sealing layer (7, 13) making the microcavity (6) hermetic, microcomponent comprising a third layer (9) arranged between the first layer (4) and the sealing layer (7, 13), an additional microcavity (11), communicating with the hole (5) and arranged between the first layer (4) and the third layer (9), and at least one additional hole (10), adjacent to the additional microcavity (11), formed in the third layer (9), offset with respect to the hole (5) and sealed by the sealing layer (7, 13),
microcomponent **characterized in that** the third layer (9) or the sealing layer (13) is a mechanically tensile-stressed layer arranged above the first layer (4), said mechanically tensile-stressed layer flexing in the direction of the first layer (4) and reducing space to be sealed by the sealing layer (7, 13).

2. Microcomponent according to claim 1, **characterized in that** the additional microcavity (11) communicates with the additional hole (10).

3. Microcomponent according to one of the claims 1 and 2, **characterized in that** the hole (5) is arranged on a highest part of the microcavity (6).

4. Microcomponent according to any one of the claims 1 to 3, **characterized in that** the offset between the hole (5) and the additional hole (10) is such that the additional hole (10) does not cover the hole (5), even partially.

5. Microcomponent according to any one of the claims 1 to 4, **characterized in that** two additional holes (10) are associated with each hole (5), so that a suspended bridge (12), formed in the third layer (9) and delineated by the two additional holes (10), covers the hole (5).

6. Method for production of a hermetically-sealed microcavity (6) of a microcomponent according to any one of the claims 1 to 5, successively comprising
- deposition of a sacrificial layer (3) designed to delineate the microcavity (6) on a substrate (2),
- deposition of a first layer (4) forming a cover, on the substrate (2) and the sacrificial layer (3),
- etching, in the first layer (4), of at least one hole (5) opening out onto the sacrificial layer (3),
- removal of the sacrificial layer (3), via the hole (5), so as to create a microcavity (6),
- deposition of a sealing layer (7, 13), so as to make the microcavity (6) hermetic,
method **characterized in that** it comprises, after etching of the hole (5) and before removal of the sacrificial layer (3),
- deposition of an additional sacrificial layer (8) covering the hole (5) and a part of the first layer (4), over the periphery of the hole (5),
- deposition of a third layer (9) on the first layer (4) and the additional sacrificial layer (8),
- etching of at least one additional hole (10), in the third layer (9), offset with respect to the hole (5) and opening out onto the additional sacrificial layer (8),
removal of the sacrificial layer (3) and of the additional sacrificial layer (8) being performed through the additional hole (10) so as to create the microcavity (6), and deposition of the sealing layer (7, 13) being performed on the third layer (9) so as to seal the additional hole (10), the third layer (9) or the sealing layer (13) being a mechanically tensile-stressed layer arranged above the first layer (4), flexing in the direction of the first layer (4) and reducing space to be sealed by the sealing layer (7, 13).

7. Method according to claim 6, **characterized in that** the third layer (9) is achieved under a tensile mechanical stress, so that the part of the third layer (9) released by removal of the additional sacrificial layer (8) flexes in the direction of the first layer (4).

8. Method according to claim 6, **characterized in that** the third layer (9) is formed by a first mechanically tensile-stressed sub-layer (9a) covered by a second mechanically compressive-stressed sub-layer (9b), the second sub-layer (9b) being removed after the sacrificial layers (3, 8) have been removed.

9. Method according to claim 6, **characterized in that**, after the sacrificial layers (3, 8) have been removed, the sealing layer (13) is formed on the third layer (9), under a tensile mechanical stress, so that the third layer (9) and the sealing layer (13) flex in the direction of the first layer (4).

## Patentansprüche

1. Mikrokomponente, die eine hermetisch abgeschlossene Mikrokavität (6) aufweist, die von einer Kappe begrenzt wird, die eine erste Schicht (4) umfasst, in der mindestens eine Öffnung (5) gebildet ist, sowie eine Verschlussschicht (7, 13), welche die Mikrokavität (6) hermetisch abdichtet, wobei die Mikrokomponente eine dritte Schicht (9), die zwischen der ersten Schicht (4) und der Verschlussschicht (7, 13) angeordnet ist, eine zusätzliche Mikrokavität (11), die mit der Öffnung (5) verbunden und zwischen der ersten (4) und dritten (9) Schicht angeordnet ist, und mindestens eine zusätzliche Öffnung (10) umfasst, die an die zusätzliche Mikrokavität (11) angrenzt, in der dritten Schicht (9) gebildet, bezüglich der Öffnung (5) versetzt angeordnet und durch die Verschlussschicht (7, 13) verschlossen ist, Mikrokomponente, die **dadurch gekennzeichnet ist, dass** die dritte Schicht (9) bzw. die Verschlussschicht (13) eine Schicht ist, die unter mechanischer Spannung steht und über der ersten Schicht (4) angeordnet ist, wobei die unter mechanischer Spannung stehende Schicht in Richtung auf die erste Schicht (4) nachgibt und eine Verkleinerung des durch die Verschlussschicht (7, 13) zu verschließenden Raums bewirkt.

2. Mikrokomponente nach Anspruch 1, **dadurch gekennzeichnet, dass** die zusätzliche Mikrokavität (11) mit der zusätzlichen Öffnung (10) verbunden ist.

3. Mikrokomponente nach einem der Ansprüche 1 und 2, **dadurch gekennzeichnet, dass** die Öffnung (5) in einem oberen Bereich der Mikrokavität (6) angeordnet ist.

4. Mikrokomponente nach einem der Ansprüche 1 bis 3, **dadurch gekennzeichnet, dass** der Versatz zwischen der Öffnung (5) und der zusätzlichen Öffnung (10) so vorgesehen ist, dass die zusätzliche Öffnung (10) die Öffnung (5) nicht bedeckt, und zwar nicht einmal teilweise.

5. Mikrokomponente nach einem der Ansprüche 1 bis 4, **dadurch gekennzeichnet, dass** jeder Öffnung (5) zwei zusätzliche Öffnungen (10) zugeordnet sind, sodass ein schwebender Verbindungssteg (12), der in der dritten Schicht (9) gebildet und von den beiden zusätzlichen Öffnungen (10) begrenzt wird, die Öffnung (5) bedeckt.

6. Verfahren zur Herstellung einer hermetisch abgedichteten Mikrokavität (6) einer Mikrokomponente nach einem der Ansprüche 1 bis 5, das nacheinander umfasst:
- das Aufbringen einer Opferschicht (3), die die Mikrokavität (6) begrenzen soll, auf ein Substrat (2),
- das Aufbringen einer ersten Schicht (4), die eine Kappe bildet, auf das Substrat (2) und die Opferschicht (3),
- das Ätzen mindestens einer zur Opferschicht (3) mündenden Öffnung (5) in die erste Schicht (4),
- das Entfernen der Opferschicht (3) durch die Öffnung (5) hindurch, um eine Mikrokavität (6) entstehen zu lassen,
- das Aufbringen einer Verschlussschicht (7, 13), um die Mikrokavität (6) hermetisch abzudichten,
Verfahren, das **dadurch gekennzeichnet ist, dass** es nach dem Ätzen der Öffnung (5) und vor dem Entfernen der Opferschicht (3) folgende Schritte umfasst:
- das Aufbringen einer zusätzlichen Opferschicht (8), die die Öffnung (5) und einen Teil der ersten Schicht (4) bedeckt, auf den Umfang der Öffnung (5),
- das Aufbringen einer dritten Schicht (9) auf die erste Schicht (4) und die zusätzliche Opferschicht (8),
- das Ätzen mindestens einer zusätzlichen Öffnung (10) in die dritte Schicht (9), die bezüglich der Öffnung (5) versetzt ist und zur zusätzlichen Opferschicht (8) hin mündet, wobei das Entfernen der Opferschicht (3) und der zusätzlichen Opferschicht (8) durch die zusätzliche Öffnung (10) hindurch erfolgt, sodass die Mikrokavität (6) entsteht, und das Aufbringen der Verschlussschicht (7, 13) auf die dritte Schicht (9) erfolgt, sodass die zusätzliche Öffnung (10) verschlossen wird,
wobei die dritte Schicht (9) oder die Verschlussschicht (13) eine Schicht ist, die unter mechanischer Spannung steht, über der ersten Schicht (4) angeordnet ist und zur ersten Schicht (4) hin nachgibt und eine Verkleinerung des mit der Verschlussschicht (7, 13) abzudichtenden Raums bewirkt.

7. Verfahren nach Anspruch 6, **dadurch gekennzeichnet, dass** die dritte Schicht (9) unter mechanischer Spannung hergestellt wird, damit der Teil der dritten Schicht (9), der durch das Entfernen der zusätzlichen Opferschicht (8) freigelegt wurde, in Richtung auf die erste Schicht (4) nachgibt.

8. Verfahren nach Anspruch 6, **dadurch gekennzeichnet, dass** die dritte Schicht (9) von einer ersten Unterschicht (9a), die unter mechanischer Spannung hergestellt wurde und von einer zweiten Unterschicht (9b) bedeckt ist, die unter mechanischer Druckspannung hergestellt wurde, gebildet wird, wobei die zweite Unterschicht (9b) nach Entfernen der Opferschichten (3, 8) entfernt wird.

9. Verfahren nach Anspruch 6, **dadurch gekennzeichnet, dass** die Verschlussschicht nach Entfernen der Opferschichten (3, 8) auf der dritten Schicht (9) unter mechanischer Spannung hergestellt wird, damit die dritte Schicht (9) und die Verschlussschicht (13) in Richtung auf die erste Schicht (4) nachgeben.
